# EUROPEAN PATENT SPECIFICATION

(11) **EP 1 906 455 B1**
(45) Date of publication and mention of the grant of the patent: **29.02.2012**
(21) Application number: 06766765.9
(22) Date of filing: 15.06.2006
(51) Int. Cl.: H01L 31/0224, H01L 31/04, H01L 31/0216

(54) **SOLAR CELL ELEMENT AND SOLAR CELL ELEMENT MANUFACTURING METHOD**
SOLARZELLENELEMENT UND VERFAHREN ZUR HERSTELLUNG EINES SOLARZELLENELEMENTS
ÉLÉMENT DE PILE SOLAIRE ET PROCÉDÉ DE FABRICATION CORRESPONDANT

(30) Priority: 22.06.2005 JP 2005181538; 29.09.2005 JP 2005283687
(43) Date of publication of application: 02.04.2008
(73) Proprietor: KYOCERA CORPORATION, Kyoto-shi, Kyoto 612-8501 (JP)
(72) Inventor: FUKUI, Kenji, KYOCERA CORPORATION, Higashiohmi-shi, Shiga 527-8555 (JP)
(74) Representative: Steil, Christian
(86) International application number: PCT/JP2006/312031
(87) International publication number: WO 2006/137322

(56) References cited:
- JP-A- 5 129 640
- JP-A- 05 095 127
- JP-A- 05 315 628
- JP-A- 59 032 179
- JP-A- 60 123 072
- JP-A- 63 204 775
- JP-A- 2002 076 400
- JP-A- 2002 093 722
- JP-A- 2002 217 435
- JP-B2- 3 255 921
- US-A- 5 320 684
- US-A- 5 766 964

## Description

The invention relates to a solar cell, in particular, to a solar cell having a collector electrode formed of an aluminum-based main component on a non-light-receiving surface of a semiconductor substrate and a manufacturing method thereof.

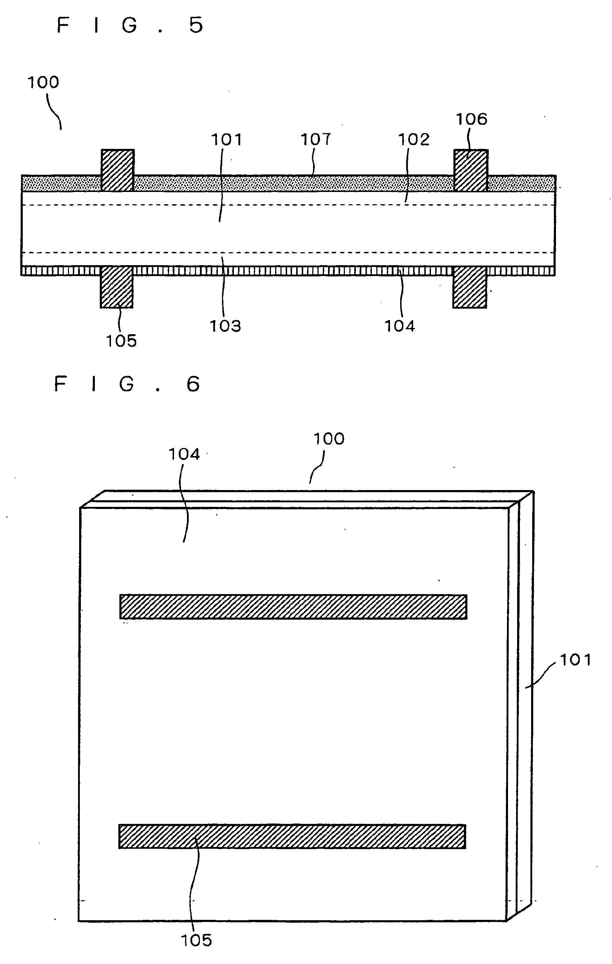

Fig. 5 is a schematic sectional view of a generally known solar cell.

The known solar cell 100 shown in Fig. 5 has an n-type diffusion layer 102 at an entire surface (upper main surface, in Fig. 5) of a p-type semiconductor substrate 101 made of, for example, polycrystalline silicon. The diffusion layer 102 is formed by diffusing an n-type dopant into the surface of the semiconductor substrate 101 to a predetermined depth. The front surface of the semiconductor substrate 101 is covered with an antireflection layer 107. Surface electrodes 106 are also formed on the front surface of the semiconductor substrate 101. The rear surface (lower main surface, in Fig. 5) of the semiconductor substrate 101 is provided with a set of rear electrodes (104, 105) including a collector electrode 104 and power output electrodes 105. In addition, a BSF (Back Surface Field) layer 103, which is a highly doped p-type diffusion layer, is formed at the rear surface of the semiconductor substrate 101.

The BSF layer 103 is generally formed during the process for forming the collector electrode 104 on the rear surface of the semiconductor substrate 101 by applying an aluminum-based collector electrode material onto the rear surface of the semiconductor substrate 101 and subsequently firing the material. In this process, the aluminum in the collector electrode material diffuses into the semiconductor substrate 101 to form the BSF layer 103.

Fig. 6 is an external perspective view of the solar cell 100 when viewed from the rear surface side.

As shown in Fig. 6, the rear surface of the known solar cell 100 is substantially covered with the collector electrode 104 mainly containing aluminum or the like, and has a plurality of (two, in Fig. 6) power output electrodes 105 mainly containing silver or the like.

Unfortunately, the known solar cell 100 has a difference in thermal shrinkage between the materials of the semiconductor substrate 101 and the collector electrode 104, and this difference produces a stress to warp the semiconductor substrate 101. The warp causes a crack in the semiconductor substrate 101.

A method to solve this problem has been known in which after the BSF layer 103 is formed by applying an aluminum-based electrode material onto the rear surface of the semiconductor substrate 101 and then firing the material, the semiconductor substrate 101 having the BSF layer 103 is immersed in hydrochloric acid to remove the aluminum-containing fired layer remaining on the surface of the semiconductor substrate 101 by chemical etching with the hydrochloric acid and, subsequently, silver or copper electrodes are formed on the exposed surface of the semiconductor substrate 101 (see, for example, Japanese Patent No. 2999867). This method removes aluminum remaining on the surface of the semiconductor substrate 101, which causes the semiconductor substrate 101 to warp while the BSF layer 103 is formed at the rear surface of the semiconductor substrate 101. Thus, the warp of the semiconductor substrate 101 is reduced.

In this method, however, tube collector electrode 104 is newly formed on the rear surface without using the aluminum remaining on the semiconductor substrate 101 after firing the electrode material. Consequently, the additional steps of treating the surface with hydrochloric acid and forming the collector electrode 104 after the etching with the hydrochloric acid increase the manufacturing cost. Disposal costs are also required to dispose of the hydrochloric acid and waste water. Thus, the method has problems in view of cost.

From US 5,320,684 a solar cell and a method of making a solar cell is known, wherein the method comprises the step of applying a coating of an aluminum metal paste onto the rear surface of the substrate in a suitable rear contact pattern, applying a layer of a glass frit paste so as to envelop the rear contact, and firing those pastes so as to conform a rear contact protected by a glass overcoating. A front contact also is formed by applying a silver metal/glass frit paste onto the anti-reflection coating in a related front contact pattern. The front and rear contacts may be fired simultaneously or in two different steps.

Accordingly, an object of the present invention is to provide a solar cell, defined by a device according to claim 9, in which the warp of the semiconductor substrate causing a crack in the solar cell is reduced and which exhibits superior output power characteristics, and methods for manufacturing the same, defined by claims 1 and 4.

To solve the problem, according to a first aspect of a method of manufacturing a solar cell, the method comprises (a) a first step of forming a collector electrode on a non-light-receiving surface of a semiconductor substrate, for forming the solar cell, having an aluminum-based component; the first step comprising (a1) forming a collector electrode material layer including an aluminum, and (a2) firing the collector electrode material layer to form a BSF layer inside the semiconductor substrate and to obtain the collector electrode, and (b) a second step of forming a passivation layer including hydrogen covering at least a part of the collector electrode.

Thus, the solar cell exhibits passivation effect of reducing recombination of carriers, which is produced by diffusing hydrogen in the thickness direction of the semiconductor substrate from the passivation layer and thus binding the hydrogen to dangling bonds in the semiconductor substrate. Consequently, the output power characteristics of the resulting solar cell are enhanced. Since the passivation effect can thus be produced, the resulting solar cell can exhibit output power characteristics superior to those of the known solar cell even if the BSF layer is not formed so as to produce a sufficient BSF effect when the collector electrode is formed. This means that a solar cell exhibiting output power characteristics superior to those of the known solar cell electrode can be achieved even if the collector electrode has a smaller thickness than the known collector electrode in a range in which a current collection effect can be produced. Thus, the first aspect can provide a solar cell in which the warp of the semiconductor substrate has been reduced and which can exhibit superior output power characteristics.

According to a second aspect of the present invention, in the method of manufacturing the solar cell according to the first aspect, the first step further comprises a3) etching the collector electrode to obtain the collector electrode having a minimum thickness for achieving the collection effect.

Thus, a BSF layer sufficient to produce the BSF effect can be formed, and the warp of the semiconductor substrate resulting from firing can be reduced by reducing the thickness of the collector electrode by etching. Consequently, in the resulting solar cell, the warp of the semiconductor substrate has been reduced, and the resulting solar cell can produce both the BSF effect and the passivation effect and exhibit superior output power characteristics.

According to a third aspect of the present invention, a method of manufacturing a solar cell comprises a first step of forming a collector electrode material layer on a non-light-receiving surface of a semiconductor for forming the solar cell and including an aluminum, a second step of forming a passivation layer covering at least a part of the collector electrode, and a third step of firing the collector electrode material layer to obtain the collector electrode including an aluminum-based component.

Thus, the resulting solar cell can produce the passivation effect of reducing the recombination of carriers, which is produced by diffusing hydrogen in the thickness direction of the semiconductor substrate from the passivation layer and thus by binding the diffused hydrogen to dangling bonds in the semiconductor substrate. In particular, firing is performed after the formation of the passivation layer, thereby promoting the diffusion of hydrogen not only during the formation of the passivation layer, but also during the firing. Accordingly, a passivation effect superior to that in the first aspect can be produced. Since such a superior passivation effect can be produced, the resulting solar cell can exhibit output power characteristics superior to those of the known solar cell even if the BSF layer is not formed so as to produce a sufficient BSF effect when the collector electrode is formed. This means that a solar cell exhibiting output power characteristics superior to those of the known solar cell can be achieved even if the collector electrode has a smaller thickness than the known collector electrode in a range in which a current collection effect can be produced.

Thus, the third aspect can provide a solar cell in which the warp of the semiconductor substrate has been reduced and which can exhibit superior output power characteristics.

According to a fourth aspect of the present invention, in a method of manufacturing a solar cell according to the third aspect, the collector electrode material layer is formed in the first step so that the collector electrode having a minimum thickness for achieving the current collector effect is formed in the third step.

Thus, the resulting solar cell can have a semiconductor substrate whose warp has been further reduced.

According to a fifth aspect of the present invention, in a method of manufacturing a solar cell according to one of the first to fourth aspects, the passivation layer is formed of silicon nitride by plasma CVD method.

According to a sixth aspect of the present invention, a solar cell comprises a semiconductor substrate for forming the solar cell, a collector electrode formed on a non-light-receiving surface of the semiconductor substrate, comprising an aluminum-based component and having a minimum thickness for exhibiting the collection effect, and a passivation layer including hydrogen covering the collector electrode.

The solar cell can produce the passivation effect of reducing the recombination of carriers, which is produced by diffusing hydrogen in the thickness direction of the semiconductor substrate from the passivation layer and thus by binding the diffused hydrogen to dangling bonds in the semiconductor substrate. Consequently, the output power characteristics are enhanced. Also, since the solar cell has a thin collector electrode with a minimum thickness that can produce a current collection effect, the warp of the semiconductor substrate is further reduced.

According to a seventh aspect of the present invention, in a solar cell according to the sixth aspect, the collector electrode is formed by forming a collector electrode material layer including an aluminum and firing the collector electrode material layer, with formation of a BSF layer inside the semiconductor substrate.

The solar cell has a BSF layer sufficient to produce the BSF effect and a collector electrode with a reduced thickness, and consequently, the warp of the semiconductor substrate is reduced. Hence, superior output power characteristics are achieved by reducing the warp of the semiconductor substrate and by sufficiently producing both the BSF effect and the passivation effect.

According to an eighth aspect of the present invention, in a solar cell according to the seventh aspect, the collector electrode is formed by etching after the firing so that the collector electrode has the minimum thickness for exhibiting the current collection effect.

In the solar cell, the warp of the semiconductor substrate resulting from firing has been reduced by etching the collector electrode, and both the BSF effect and the passivation effect are sufficiently produced. Consequently, superior output power characteristics are achieved.

According to a ninth aspect of the present invention, in a solar cell according to one of the sixth to eighth aspects, the collector electrode is partially formed on the non-light-receiving surface of the substrate, and the solar cell further comprises an output electrode electrically connected to at least a part of the collector electrode, having a metal-based component having a higher conductivity than aluminum.

According to a tenth aspect of the present invention, in a solar cell according to one of the sixth to eighth aspects, the passivation layer is made of silicon nitride.

According to an eleventh aspect of the present invention, a solar cell is manufactured by the method of manufacturing the solar cell of one of the first to fifth aspects.

Fig. 1 is a sectional view of the structure of a solar cell according to an embodiment of the present invention.
Fig. 2 is an external perspective view of the solar cell according to the embodiment of the present invention when viewed from the rear surface side.
Fig. 3 is a representation showing a first method for manufacturing the solar cell according to the embodiment of the present invention.
Fig. 4 is a representation showing a second method for manufacturing the solar cell according to an embodiment of the present invention.
Fig. 5 is a representation of the structure of a known solar cell.
Fig. 6 is an external perspective view of the known solar cell when viewed from the rear surface side.

### <Structure of Solar Cell>

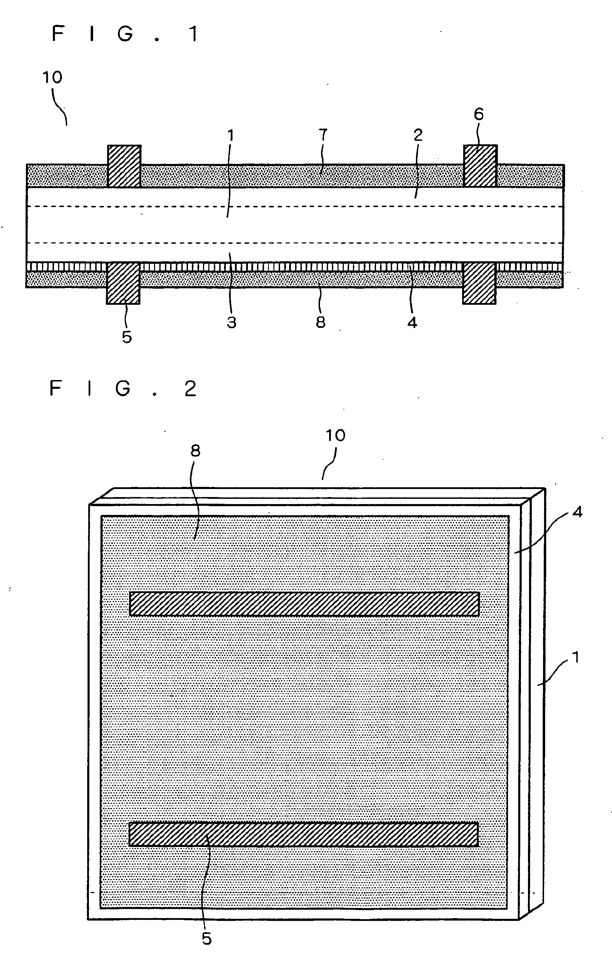

The structure of a solar cell according to an embodiment of the present invention will be described in detail with reference to Figs. 1 and 2. The dimensional proportions of each part of the solar cell shown in the drawings including Figs. 1 and 2 do not necessarily correspond to the actual dimensions.

Fig. 1 shows a section of a solar cell 10 according to the present embodiment. As shown in Fig. 1, the solar cell 10 of the present embodiment includes a semiconductor substrate 1, a diffusion layer 2, a BSF layer 3, a collector electrode 4, power output electrodes 5, surface electrodes 6, an antireflection layer 7, and a passivation layer 8. The, front surface and the rear surface of the semiconductor substrate 1 refer to the light-reception surface and the non-light-receiving surface, respectively. In the solar cell shown in Fig. 1, the upper main surface is the front surface and the lower main surface is the rear surface. Fig. 2 is an external perspective view of the solar cell 10 when viewed from the rear surface side.

The semiconductor substrate 1 is made of monocrystalline silicon or polycrystalline silicon. The semiconductor substrate 1 is formed by cutting a semiconductor ingot prepared by a crystal pulling method for a monocrystalline silicon or by casting for a polycrystalline silicon to, for example, about 15 cm by 15 cm and slicing the cut piece to a thickness of 300 µm or less, preferably 250 µm or less. Since polycrystalline silicon can be easily mass-produced, polycrystalline silicon is much more advantageous in cost than monocrystalline silicon. The semiconductor substrate 1 may be of p-type or n-type. The semiconductor substrate 1 is used for the solar cell in the manufacturing process after the surface is cleaned by etching with alkaline solution to remove impurities trapped onto the surface or a portion damaged during slicing or cutting.

The diffusion layer 2 is a semiconductor region having a conductive type opposite to that of the semiconductor substrate 1 and is formed at a main surface of the semiconductor substrate 1 so as to establish a semiconductor junction inside the semiconductor substrate 1. The diffusion layer 2 formed by diffusing a specific dopant exhibits n-type characteristics if the semiconductor substrate 1 is of p-type, or p-type characteristics if the semiconductor substrate 1 is of n-type. For preparing the diffusion layer 2, the semiconductor substrate 1 is placed in, for example, a predetermined reaction chamber, and a gas used as the diffusion source is introduced into the chamber while the semiconductor substrate 1 is heated. For example, a p-type semiconductor substrate 1 is generally provided with a n-type diffusion layer 2 at the surface by a gas phase diffusion process in which phosphate glass (not shown) containing an n-type dopant phosphorus (P), from which the dopant is diffused, is formed on the surface of the semiconductor substrate 1 by delivering phosphoryl chloride (POCl₃) while the surface of the semiconductor substrate 1 is subjected to thermal diffusion. The phosphate glass formed on the surface of the semiconductor substrate 1 is removed by immersing in, for example, a diluted hydrofluoric acid solution. The surface having the diffusion layer 2 of the two main surfaces of the semiconductor substrate 1 is intended for the front surface (light-reception surface).

The antireflection layer 7 is formed on the front surface of the semiconductor substrate 1 to control reflection of light at the surface of the semiconductor substrate 1. The refractive index and thickness of the antireflection layer 7 are set in consideration of the difference in refractive index from the semiconductor substrate 1 or other factors so that the antireflection layer 7 can function as intended. For example, a silicon semiconductor substrate 1 can have a refractive index of about 1.8 to 2.3 and a thickness of about 500 to 1200 A.

The antireflection layer 7 can be formed of Si₃N₄, TiO₂, SiO₂, MgO, ITO, SnO₂, ZnO, and so forth by a deposition such as plasma CVD, vapor deposition, or sputtering. In general, the antireflection layer 7 is formed by plasma CVD at a temperature in the range of 400 to 500°C.

If a Si₃N₄ antireflection layer 7 is formed by plasma CVD, a raw material gas prepared by diluting a mixed gas of, for example, silane (SiH₄) and ammonia (NH₃) with nitrogen (N₂) is turned into plasma by grow discharge decomposition and the resulting Si₃N₄ is deposited onto the semiconductor substrate 1 to form a Si₃N₄ coating as the antireflection layer 7.

If the antireflection layer 7 contains hydrogen (H₂), the hydrogen is normally diffused in the thickness direction of the semiconductor substrate 1 by heating during and after deposition (for example, by heating for firing the electrode described later) and is bound to dangling bonds (uncombined hands) in the semiconductor substrate 1. The formation of such bonds can advantageously reduce the probability that carriers are trapped to the dangling bonds (recombination), hence producing a so-called passivation effect. A Si₃N₄ film formed by plasma CVD has the passivation effect, and is accordingly suitable as the antireflection layer 7.

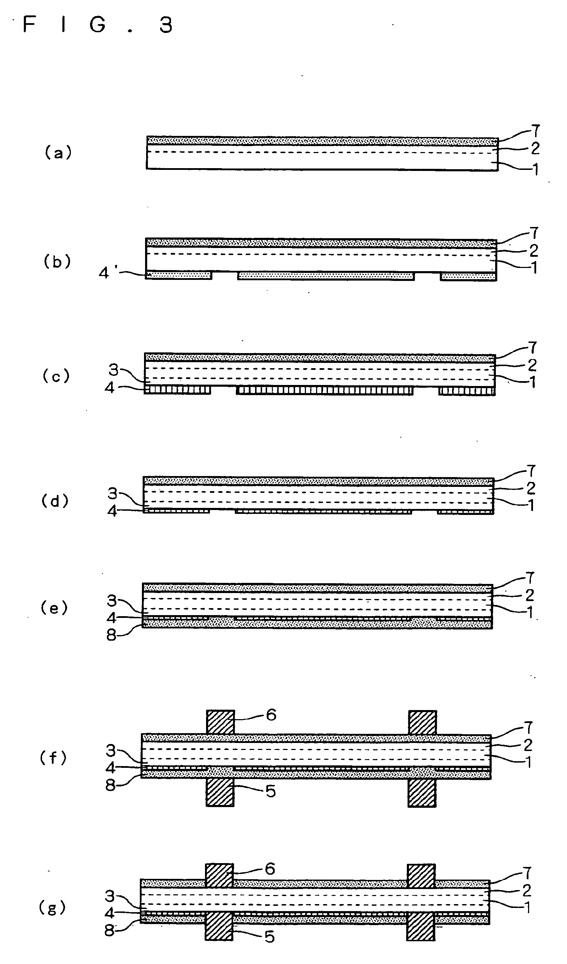

The collector electrode 4 is formed over substantially the entire rear surface of the semiconductor substrate 1 to collect carriers produced in the semiconductor substrate 1. Preferably, the collector electrode 4 has an aluminum-based component. For forming the collector electrode 4, a collector electrode material containing aluminum powder, a resin binder, and an organic solvent (may further contain glass frit) is applied onto the rear surface of the semiconductor substrate 1 to form a collector electrode material layer (see Fig. 3(b)), and the material layer is fired in a firing furnace or the like at a temperature of at most 600 to 800°C for about 1 to 30 minutes.

The BSF layer 3 is intended to prevent the reduction of power generation efficiency resulting from the recombination of carriers in the vicinity of the rear surface of the semiconductor substrate 1. The BSF layer 3 is a p-type layer in which carriers are present at a high concentration. The BSF layer 3 is formed by diffusing a p-type dopant aluminum from the collector electrode material into the semiconductor substrate 1 during firing for forming the collector electrode 4. By forming the BSF layer 3, an electric field is generated inside the rear surface of the semiconductor substrate 1. The electric field accelerates carriers produced inside the semiconductor substrate 1 in the vicinity of the rear surface. Consequently, power can be efficiently extracted. Thus, the solar cell 10 exhibits a so-called BSF effect. The presence of the BSF layer 3 increases the photosensitivity of the solar cell 10 in the long wavelength region and alleviates the degradation of the output power characteristics of the solar cell at high temperatures.

From the viewpoint of forming the BSF layer 3, the collector electrode material layer 4' can be formed by applying the collector electrode material only to an area sufficient to produce the BSF effect. The pattern of the applied collector electrode material is determined so as not to increase the electrical resistance of the collector electrode 4. If the collector electrode material is applied so as to occupy about 90% of the rear surface of the semiconductor substrate 1, the BSF layer 3 can be formed at substantially the entire region of the semiconductor substrate 1 and superior output power characteristics can be produced.

The collector electrode material layer 4' may be formed so as to have openings two-dimensionally, as in the case, for example, in which the collector electrode material layer 4' is formed over an entire region except the regions where the power output electrodes 5 are to be formed. This can be realized by printing a pattern in positions where the power output electrodes 5 are to be formed. In this instance, the stress on the semiconductor substrate 1 is distributed after the below-described firing, and accordingly the warp of the semiconductor substrate 1 is reduced.

The passivation layer 8 is formed to the outside of the collector electrode 4 on the rear surface of the semiconductor substrate 1. The passivation layer 8 is intended to produce the above-mentioned passivation effect. More specifically, the passivation layer 8 allows hydrogen to diffuse in the thickness direction of the semiconductor substrate 1 from the passivation layer 8 and thus to bind to dangling bonds (uncombined hands) in the semiconductor substrate 1 during the deposition of the passivation layer 8 and the subsequent heating, thereby reducing the probability that carriers are trapped to the dangling bonds. (recombination).

Although the passivation layer 8 is preferably formed of Si₃N₄ by plasma CVD, other materials and processes may be applied to the formation of the passivation layer without particular limitation, as long as the passivation effect can be produced. For example, the passivation layer may be a SiO₂ film, TiO₂ film, or MgF₂ film containing hydrogen. Alternatively, the passivation layer may have a multilayer structure including a plurality of layers made of different materials. The thickness of the passivation layer 8 is preferably in the range of about 100 to 2000 A, and more preferably in the range of about 200 to 1500 Å.

Since the solar cell 10 of the present embodiment thus has the passivation layer 8 for producing the passivation effect on the rear surface of the semiconductor substrate 1, the recombination between the carriers and the dangling bonds in the semiconductor substrate 1 can be prevented effectively. Consequently, the solar cell 10 can exhibit enhanced output power characteristics. If the antireflection layer 7 is provided so as to produce a passivation effect, the recombination between the carriers and the dangling bonds can be prevented more effectively. Accordingly, the solar cell can exhibit superior output power characteristics.

The passivation layer 8 and the BSF layer 3 have their respective functions, but have a similarity in preventing the recombination of carriers. The BSF layer 3 is formed in association with the formation of the aluminum-based collector electrode 4, more specifically in association with the firing of the collector electrode material, as described above. If the passivation layer 8 is not provided as in the known solar cell, the collector electrode 4 is formed thick so that the collector electrode 4 can produce a sufficient current collection effect and so that the BSF layer 3 can produce a sufficient BSF effect. Consequently, the difference in thermal expansion coefficient between the semiconductor substrate 1 and the collector electrode 4 causes the semiconductor substrate 1 to warp. In contrast, if the thickness of the collector electrode 4 is reduced to prevent the warp, it becomes difficult to form a BSF layer 3 that can produce a sufficient BSF effect.

On the other hand, the solar cell 10 of the present embodiment has the passivation layer 8 that can produce the passivation effect; hence it is not necessary that the collector electrode 4 be formed thick. The presence of the passivation layer 8 allows the thickness of the collector electrode 4 to be reduced to the extent that a current collection effect can be produced. By reducing the thickness of the collector electrode 4, the warp of the semiconductor substrate 1 is reduced. The minimum thickness that can produce the current collection effect depends on the type, size, and other factors of the semiconductor substrate 1 used for the production of the solar cell 10. For example, if a polycrystalline silicon substrate having a horizontal size of about 15 cm by 15 cm and a thickness of about 250 µm is used as the semiconductor substrate 1, the thickness of the collector electrode 4 after firing can be 30 µm or less, preferably 25 µm or less, and more preferably 20 µm or less.

As a matter of course, the antireflection layer 7 also contributes to achieving a solar cell 10 superior in output power characteristics if the antireflection layer 7 is formed so as to produce a passivation effect.

The surface electrodes 6 and the power output electrodes 5 are provided on the front surface and the rear surface of the semiconductor substrate 1, respectively. The surface electrodes 6 and the power output electrodes 5 are preferably formed of a metal having a higher electric conductivity than aluminum. For example, silver is preferably used. Gold, platinum, palladium, copper, and the like may be used. The surface electrodes 6 and the power output electrodes 5 are formed by applying a paste (electrode material) containing silver powder, a glass frit, a resin binder, or an organic solvent by a known coating technique, such as screen printing, and then firing the paste.

As described above, the solar cell of the present embodiment has the collector electrode formed thinner than the known collector electrode and the passivation layer is provided to the outside of the collector electrode. Consequently, the warp of the semiconductor substrate is reduced and the recombination of carriers is prevented to enhance the output power characteristics.

### <First Manufacturing Method of Solar cell>

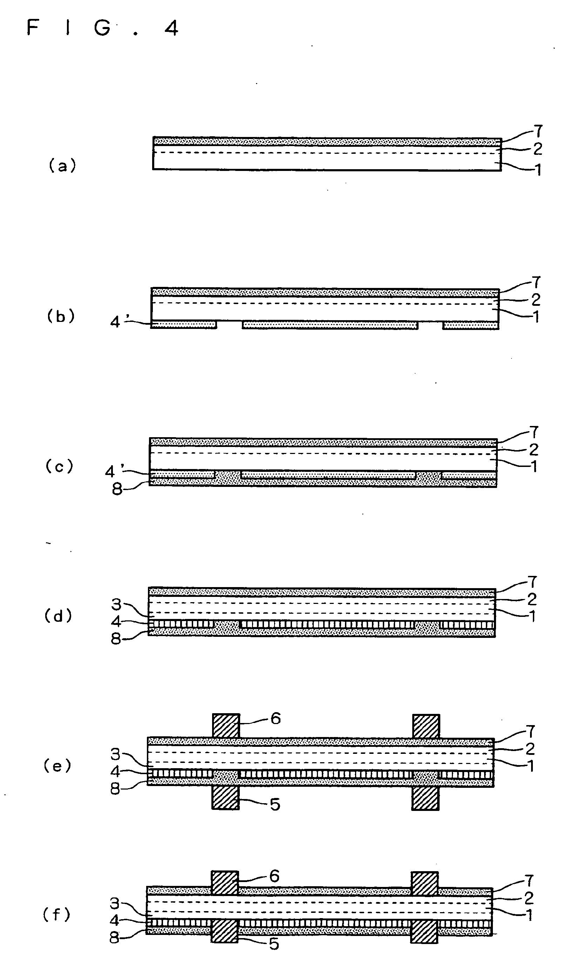

A method for manufacturing the solar cell of the present embodiment will now be described in detail with reference to Figs. 3 and 4. The following description will illustrate a solar cell having a p-type semiconductor substrate 1 as an example.

Fig. 3 is a representation of a procedure of a first method for manufacturing the solar cell 10.

In the first manufacturing method, a diffusion layer 2 is formed at a main surface (upper surface, in Fig. 3) of the semiconductor substrate 1, as shown in Fig. 3(a), so as to be a semiconductor region having an n-type conductivity, which is opposite to that of the semiconductor substrate 1, by, for example, a gas phase diffusion process or the like. Then an antireflection layer 7 having a predetermined refractive index and thickness is formed over the surface having the diffusion layer 2 of the semiconductor substrate 1. In the present embodiment, a Si₃N₄ layer is formed by plasma CVD so that the antireflection layer 7 can produce the passivation effect.

After the unwanted layer formed on the rear surface of the semiconductor substrate 1 during the formation of the diffusion layer 2 has been removed, at least a collector electrode material layer 4' is formed over substantially the entire rear surface of the semiconductor substrate 1, as shown in Fig. 3(b). The collector electrode material layer 4' is formed by applying a collector electrode material containing aluminum powder, a resin binder, and an organic solvent by screen printing or the like. The collector electrode material may further contain a glass frit. The collector electrode material layer 4' has such a thickness as allows a BSF layer 3 to produce a BSF effect sufficient to enhance the output power characteristics by the below-described firing.

Fig. 3(b) (and Fig. 4(b) described below) shows a collector electrode material layer 4' formed over an entire region except the regions where power output electrodes 5 are to be formed.

The resulting collector electrode material layer 4' is fired with the semiconductor substrate 1. Thus, a collector electrode 4 and a BSF layer 3, which is a highly doped p type layer formed by diffusing p-type dopant aluminum into the semiconductor substrate 1, are completed, as shown in Fig. 3(c).

Subsequently, the collector electrode 4 is etched in the thickness direction to reduce the thickness, as shown in Fig. 3(d). Etching methods include blasting, reactive etching, and ultrasonic etching. Preferably, the etching is performed so that the remaining portion of the collector electrode 4 has a minimum thickness that can produce a current collection effect.

After reducing the thickness of the collector electrode 4, a passivation layer 8 is formed so as to cover at least part of the collector electrode 4, as shown in Fig. 3(e). In this embodiment, a Si₃N₄ layer is formed by plasma CVD.

Turning now to Figs. 3(f) and 3(g), a surface electrode material containing silver or the like is applied onto the antireflection layer 7 and a power output electrode material containing silver or the like is also applied onto the passivation layer 8. These materials are fired to form surface electrodes 6 and power output electrodes 5 that are in contact with the semiconductor substrate 1. In other words, the surface electrodes 6 and the power output electrodes 5 are formed by a so-called fire-through process.

Thus, the solar cell 10 is completed through the above-described procedure.

In the first manufacturing method, the collector electrode 4 that has been formed is etched to reduce the thickness, as described above. Thus, the reduction of the thickness reduces the stress placed between the semiconductor substrate 1 and the collector electrode 4 by firing, thereby reducing the warp of the semiconductor substrate 1 resulting from the firing. This method performs etching after the firing of the collector electrode material layer 4', that is, after the formation of the BSF layer 3. Consequently, the resulting solar cell 10 can have a BSF layer 3 with such a thickness as can produce a BSF effect sufficient to enhance the output power characteristics in spite of the thinner collector electrode 4 than the known collector electrode. In addition, since the collector electrode 4 on the semiconductor substrate 1 is partially etched in the thickness direction, but not removed completely, it is not necessary to form another collector electrode.

In the solar cell 10 manufactured by the first manufacturing method, the BFS layer 3 has been provided so as to produce a sufficient BSF effect, and the antireflection layer 7 and the passivation layer 8 are provided so as to produce a passivation effect together. Accordingly, the solar cell 10 exhibits output power characteristics superior to those of the known solar cell.

Thus, the first manufacturing method can provide a solar cell in which the warp of the semiconductor substrate has been reduced and which exhibits superior output power characteristics.

### <Second Manufacturing Method of Solar Cell>

A second method for manufacturing the solar cell of the present invention will now be described. Fig. 4 is a representation of a procedure of a second method for manufacturing the solar cell 10.

In the second manufacturing method, first, a diffusion layer 2 is formed at a main surface (upper surface, in Fig. 3) of the semiconductor substrate 1, as shown in Fig. 4(a), so as to be a semiconductor region having an n-type - conductivity, which is opposite to that of the semiconductor substrate 1, by, for example, a gas phase diffusion process or the like in the same manner as in the first manufacturing method. Then an antireflection layer 7 having a predetermined refractive index and thickness is formed over the surface of the diffusion layer 2 of the semiconductor substrate 1. In the present embodiment, a Si₃N₄ layer is formed by plasma CVD so that the antireflection layer 7 can produce the passivation effect.

In the second manufacturing method, the formation of the antireflection layer 7 is not necessarily performed at this time, and may be performed any time before the below-describe surface electrode material layer 6' is formed.

After the unwanted layer formed on the rear surface of the semiconductor substrate 1 during the formation of the diffusion layer 2 has been removed, a collector electrode material layer 4' is formed over substantially the entire rear surface of the semiconductor substrate 1, as shown in Fig. 4(b). The collector electrode material layer 4' is formed by applying a collector electrode material containing aluminum powder, a resin binder, and an organic solvent by screen printing or the like. The collector electrode material may further contain a glass frit. In the second manufacturing method, the thickness of the collector electrode material layer 4' is set so that the collector electrode 4 produced by the below-described firing has a smaller thickness than the conventional thickness, and preferably a minimum thickness that can produce a current collection effect. The collector electrode material layer 4' shown in Fig. 4(b) is provided over the entire region except the regions where power output electrodes 5 are to be formed in a subsequent step.

After the formation of the collector electrode material layer 4', a passivation layer 8 is formed so as to cover at least part of the collector electrode material layer 4', as shown in Fig. 4(c). The passivation layer 8 shown in Fig. 4(c) is provided so as to cover substantially the entire surface of the collector electrode material layer 4'. In the present embodiment, a Si₃N₄ layer is formed by plasma CVD.

After the formation of the passivation layer 8, the collector electrode material layer 4', the passivation layer 8, and the semiconductor substrate 1 are fired together. Thus, the collector electrode 4 is formed, and aluminum of the p-type dopant, is diffused into the semiconductor substrate 1, so that the highly doped p-type BSF layer 3 is formed, as shown in Fig. 4(d).

Turning now to Figs. 4(e) and 4(f), a surface electrode material containing silver or the like is applied onto the antireflection layer 7 and a power output electrode material containing silver or the like is applied onto the passivation layer 8. These materials are fired to form surface electrodes 6 and power output electrodes 5 that are in contact with the semiconductor substrate 1. In other words, the surface electrodes 6 and the power output electrodes 5 are formed by a so-called fire-through process.

Thus, the solar cell 10 is completed through the above-described procedure.

In the second manufacturing method, unlike the first manufacturing method, the collector electrode 4 is formed to a thickness smaller than the conventional thickness, preferably to a minimum thickness that can produce a current collection effect. Consequently, the stress placed between the semiconductor substrate 1 and the collector electrode 4 by firing can be reduced, and accordingly, the warp of the semiconductor substrate 1 resulting from the firing is reduced.

In the solar cell 10 manufactured by the second manufacturing method, the antireflection layer 7 and the passivation layer 8 are provided so as to produce a passivation effect together. Thus, the passivation effect can be produced more effectively.

If the passivation layer 8 is formed after the firing for forming the BSF layer 3 and the collector electrode 4, as in the first manufacturing method, the hydrogen in the passivation layer 8 is diffused into the semiconductor substrate 1 in the thickness direction only during the formation of the passivation layer 8. On the other hand, in the second manufacturing method, firing is performed after the formation of the passivation layer 8, and the diffusion of the hydrogen occurs not only during the formation of the passivation layer as in the first manufacturing method, but also during the firing, following the growth of the BSF layer 3 (diffusion of aluminum from the collector electrode material layer 4'). In this instance, the diffusion is not affected by the collector electrode material layer 4'. Consequently, the solar cell 10 manufactured by the second manufacturing method can produce a stronger passivation effect than the solar cell 10 manufactured by the first manufacturing method. Thus, the solar cell 10 can exhibit superior output power characteristics.

Thus, the second manufacturing method can provide a solar cell in which the warp of the semiconductor substrate has been reduced and which exhibits superior output power characteristics.

### <Modification>

The present invention is not limited to the above-disclosed embodiments, and various changes and modifications may be made without departing from the scope of the invention.

The surface electrodes 6 and the power output electrodes 5 may be formed by another method instead of the fire-through process. For example, portions of the antireflection layer 7 and passivation layer 8 in which the surface electrodes 6 or the power output electrodes 5 are to be formed are removed in advance, and a paste of the surface electrode material or the power output electrode material containing, for example, silver powder, a glass frit, a resin binder, and an organic solvent is applied to the regions where the antireflection layer 7 and passivation layer 8 are removed by screen printing or the like, followed by firing. However, this method is complicated.

In the above-described embodiments, the collector electrode 4 is not formed in the regions where the power output electrodes 5 are to be formed. Since the collector electrode 4 is formed to a minimum thickness that can produce a current collection effect, however, the power output electrodes 5 can be formed so as to have a sufficient adhesion and contact resistance to the semiconductor substrate 1 even if the collector electrode 4 is formed over substantially the entire rear surface of the semiconductor substrate 1 and subsequently a power output electrode material is applied onto the collector electrode 4 and then fired to form the power output electrodes 5.

Even if the passivation layer is provided to a solar cell whose electrodes are all provided on the rear surface, a sufficient passivation effect can be produced.

The arrangement pattern of the power output electrodes 5 is not limited to that shown as an example in Figs. 1 to 6. For example, the power output electrodes 5 may be in a form of lines as shown in the figures, or in a form of dots. Also, the number of the lines or dots is not particularly limited.

The firing for forming the collector electrode may be performed simultaneously with the firing for forming the surface electrodes and the power output electrodes.

As an alternative to the manufacturing methods described above, the collector electrode material may be applied to the regions where the collector electrode 4 is to be formed on the rear surface of the semiconductor substrate 1, subsequently the power output electrode material containing silver may be applied to the regions where the power output electrodes 5 are to be formed, and further the passivation layer 8 may be formed over the power output electrodes 5. In this instance, the collector electrode material and the power output electrode material may be applied in that order, or vice versa. The passivation layer 8 over the power output electrodes 5 may be removed before firing, or the power output electrodes may break the passivation layer 8 when the electrodes are fired.

## Claims

1. A method of manufacturing a solar cell (10), comprising:
(a) a first step of preparing a semiconductor substrate (1) having a light-receiving surface and a non-light-receiving surface and forming a collector electrode (4) comprising aluminum as a main component on the non-light-receiving surface; the first step comprising,
(a1) forming a collector electrode material layer (4') including aluminum on the non-light-receiving surface, and
(a2) firing the collector electrode material layer (4') to obtain the collector electrode (4), and
(b) a second step of forming a passivation layer (8) including hydrogen covering at least a part of the collector electrode (4).

2. The method of manufacturing the solar cell according to claim 1, wherein the first step further comprises:
(a3) etching the collector electrode (4) in a thickness direction of the collector electrode (4) after firing the collector electrode material layer (4').

3. The method of manufacturing the solar cell according to claim 1, wherein firing the collector electrode material layer (4') further comprises forming a BSF layer (3) inside the semiconductor substrate (1).

4. A method of manufacturing a solar cell (10), comprising:
a first step of preparing a semiconductor substrate (1) having a light-receiving surface and a non-light-receiving surface and forming a collector electrode material layer (4') on the non-light-receiving surface of the semiconductor substrate (1), including aluminum,
a second step of forming a passivation layer (8) including hydrogen covering at least a part of the collector electrode material layer (4'), and
a third step of firing the collector electrode material layer (4') to obtain the collector electrode (4).

5. The method of manufacturing the solar cell according to claim 1 and 4, wherein the second step further comprises diffusing the hydrogen of the passivation layer (8) into the semiconductor substrate (1) through the collector electrode (4).

6. The method of manufacturing the solar cell according to claim 4, wherein firing the collector electrode material layer (4') further comprises diffusing the hydrogen of the passivation layer (8) into the semiconductor substrate (1) through the collector electrode material layer (4').

7. The method of manufacturing the solar cell according to claim 1 or 4, wherein the passivation layer (8) is formed by plasma CVD method.

8. The method of manufacturing the solar cell according to claim 1 or 4, wherein the passivation layer (8) includes silicon nitride.

9. A solar cell (10) comprising:
a semiconductor substrate (1) having a light-receiving surface and a non-light-receiving surface,
a collector electrode (4) on the non-light-receiving surface of the semiconductor substrate (1), comprising aluminum as a main component, and
a passivation layer (8) including hydrogen covering at least a part of the collector electrode (4).

10. The solar cell according to claim 9, wherein the semiconductor substrate (1) includes a BSF layer.

11. The solar cell according to claim 9, further comprising:
an anti-reflection layer (7) on the light-receiving surface of the semiconductor substrate (1), including hydrogen.

12. The solar cell according to claim 9, wherein the passivation layer (8) includes silicon nitride.

13. The solar cell according to claim 9, wherein the semiconductor substrate (1) includes hydrogen.

14. The solar cell according to claim 13, wherein the collector electrode (4) includes hydrogen.

15. The solar cell according to claim 9, wherein the collector electrode (4) has a thickness of not more than 30 µm.

## Patentansprüche

1. Verfahren zum Herstellen einer Solarzelle (10), mit:
(a) einem ersten Schritt des Bereitstellens eines Halbleitersubstrates (1), das eine lichtempfangende Oberfläche und eine nicht-lichtempfangende Oberfläche aufweist, und des Bildens einer Kollektorelektrode (4), die Aluminium als eine Hauptkomponente aufweist, und zwar auf der nicht-lichtempfangenden Oberfläche, wobei der erst Schritt beinhaltet,
(a1) Bilden einer Kollektorelektrodenmaterialschicht (4'), die Aluminium beinhaltet, und zwar auf der nicht-lichtempfangenden Oberfläche, und
(a2) Brennen der Kollektorelektrodenmaterialschicht (4'), um die Kollektorelektrode (4) zu bilden; und
(b) einem zweiten Schritt des Bildens einer Passivierungsschicht (8), die Wasserstoff beinhaltet und die wenigstens einen Teil der Kollektorelektrode (4) bedeckt.

2. Verfahren zum Herstellen der Solarzellen nach Anspruch 1, wobei der erste Schritt ferner beinhaltet:
(a3) Ätzen der Kollektorelektrode (4) in einer Richtung der Dicke der Kollektorelektrode (4) nach dem Brennen der Kollektorelektrodenmaterialschicht (4').

3. Verfahren zum Herstellen der Solarzellen nach Anspruch 1, wobei das Brennen der Kollektorelektrodenmaterialschicht (4') ferner Bilden einer BSF Schicht (3) innerhalb des Halbleitersubstrats (1) beinhaltet.

4. Verfahren zum Herstellen einer Solarzelle (10), mit:
einem ersten Schritt des Bereitstellens eines Halbleitersubstrats (1), das eine lichtempfangende Oberfläche und einer nicht-lichtempfangenden Oberfläche aufweist, und des Bildens einer Kollektorelektrodenmaterialschicht (4'), die Aluminium beinhaltet, und zwar auf der nicht-lichtempfangenden Oberfläche des Halbleitersubstrats (1),
einem zweiten Schritt des Bildens einer Passivierungsschicht (8), die Wasserstoff beinhaltet und die wenigstens einen Teil der Kollektorelektrodenmaterialschicht (4') bedeckt, und
einem dritten Schritt des Brennens der Kollektorelektrodenmaterialschicht (4'), um die Kollektorelektrode (4) zu bilden.

5. Verfahren zum Herstellen der Solarzelle nach Anspruch 1 und 4, wobei der zweite Schritt ferner ein Diffundieren des Wasserstoffs der Passivierungsschicht (8) in das Halbleitersubstrat (1) durch die Kollektorelektrode (4) hindurch beinhaltet.

6. Verfahren zum Herstellen der Solarzelle nach Anspruch 4, wobei das Brennen der Kollektorelektrodenmaterialschicht (4') ferner ein Diffundieren des Wasserstoffs der Passivierungsschicht (8) in das Halbleitersubstrat (1) durch die Kollektorelektrodenmaterialschicht (4') hindurch beinhaltet.

7. Verfahren zum Herstellen der Solarzelle nach Anspruch 1 oder 4, wobei die Passivierungsschicht (8) durch ein Plasma CVD Verfahren gebildet wird.

8. Verfahren zum Herstellen der Solarzelle nach Anspruch 1 oder 4, wobei die Passivierungsschicht (8) Siliziumnitrit beinhaltet.

9. Solarzelle (10) mit:
einem Halbleitersubstrat (1), das eine lichtempfangende Oberfläche und eine nicht-lichtempfangende Oberfläche aufweist,
einer Kollektorelektrode (4) auf der nicht-lichtempfangenden Oberfläche des Halbleitersubstrats (1), die Aluminium als eine Hauptkomponente beinhaltet, und
einer Passivierungsschicht (8), die Wasserstoff beinhaltet und die wenigstens einen Teil der Kollektorelektrode (4) bedeckt.

10. Eine Solarzelle nach Anspruch 9, wobei das Halbleitersubstrat (1) eine BSF Schicht beinhaltet.

11. Solarzelle nach Anspruch 9, ferner mit:
einer Antireflexionsschicht (7) auf der lichtempfangenden Oberfläche des Halbleitersubstrats (1), die Wasserstoff beinhaltet.

12. Solarzelle nach Anspruch 9, wobei die Passivierungsschicht (8) Siliziumnitrit beinhaltet.

13. Solarzelle nach Anspruch 9, wobei das Halbleitersubstrat (1) Wasserstoff beinhaltet.

14. Solarzelle nach Anspruch 13, wobei die Kollektorelektrode (4) Wasserstoff beinhaltet.

15. Solarzelle nach Anspruch 9, wobei die Kollektorelektrode (4) eine Dicke von nicht mehr als 30 µm aufweist.

## Revendications

1. Procédé de fabrication d'une pile solaire (10), comprenant :
(a) une première étape consistant à préparer un substrat semi-conducteur (1) ayant une surface de réception de lumière et une surface ne recevant pas de lumière, et à former une électrode collectrice (4) comprenant de l'aluminium comme constituant principal sur la surface ne recevant pas de lumière ; la première étape consistant à
(a1) former une couche de matériau (4') d'électrode collectrice comprenant de l'aluminium sur la surface ne recevant pas de lumière, et
(a2) cuire la couche de matériau (4') d'électrode collectrice pour obtenir l'électrode collectrice (4), et
(b) une seconde étape consistant à former une couche de passivation (8) comprenant de l'hydrogène recouvrant au moins une partie de l'électrode collectrice (4).

2. Procédé de fabrication de la pile solaire selon la revendication 1, dans lequel la première étape consiste en outre à :
(a3) graver l'électrode collectrice (4) dans la direction de l'épaisseur de l'électrode collectrice (4) après avoir cuit la couche de matériau (4') d'électrode collectrice.

3. Procédé de fabrication de la pile solaire selon la revendication 1, dans lequel l'étape consistant à cuire la couche de matériau (4') d'électrode collectrice consiste en outre à former une couche BSF (3) à l'intérieur du substrat semiconducteur (1).

4. Procédé de fabrication d'une pile solaire (10), comprenant :
une première étape consistant à préparer un substrat semi-conducteur (1 ) ayant une surface de réception de lumière et une surface ne recevant pas de lumière, et à former une couche de matériau (4') d'électrode collectrice sur la surface ne recevant pas de lumière du substrat semi-conducteur (1), comprenant de l'aluminium,
une deuxième étape consistant à former une couche de passivation (8) comprenant de l'hydrogène recouvrant au moins une partie de la couche de matériau (4') d'électrode collectrice, et
une troisième étape consistant à cuire la couche de matériau (4') d'électrode collectrice pour obtenir l'électrode collectrice (4).

5. Procédé de fabrication de la pile solaire selon les revendications 1 à 4, dans lequel la deuxième étape consiste en outre à diffuser l'hydrogène de la couche de passivation (8) dans le substrat semi-conducteur (1) à travers l'électrode collectrice (4).

6. Procédé de fabrication de la pile solaire selon la revendication 4, dans lequel l'étape consistant à cuire la couche de matériau (4') d'électrode collectrice consiste en outre à diffuser l'hydrogène de la couche de passivation (8) dans le substrat semi-conducteur (1) à travers la couche de matériau (4') d'électrode collectrice.

7. Procédé de fabrication de la pile solaire selon les revendications 1 à 4, dans lequel la couche de passivation (8) est formée par un procédé de dépôt chimique en phase vapeur assisté par plasma.

8. Procédé de fabrication de la pile solaire selon les revendications 1 à 4, dans lequel la couche de passivation (8) comprend du nitrure de silicium.

9. Pile solaire (10), comprenant :
un substrat semi-conducteur (1) ayant une surface de réception de lumière et une surface ne recevant pas de lumière,
une électrode collectrice (4) sur la surface ne recevant pas de lumière du substrat semi-conducteur (1), comprenant de l'aluminium comme constituant principal, et
une couche de passivation (8) comprenant de l'hydrogène recouvrant au moins une partie de l'électrode collectrice (4).

10. Pile solaire selon la revendication 9, dans laquelle le substrat semi-conducteur (1) comprend une couche BSF.

11. Pile solaire selon la revendication 9, comprenant en outre :
une couche antireflet (7) sur la surface de réception de lumière du substrat semi-conducteur (1), comprenant de l'hydrogène.

12. Pile solaire selon la revendication 9, dans laquelle la couche de passivation (8) comprend du nitrure de silicium.

13. Pile solaire selon la revendication 9, dans laquelle le substrat semi-conducteur (1) comprend de l'hydrogène.

14. Pile solaire selon la revendication 13, dans laquelle l'électrode collectrice (4) comprend de l'hydrogène.

15. Pile solaire selon la revendication 9, dans laquelle l'électrode collectrice (4) a une épaisseur n'excédant pas 30 µm.
